# EUROPÄISCHE PATENTANMELDUNG

(11) **EP 0 810 303 A1**
(43) Veröffentlichungstag der Anmeldung: **03.12.1997**
(21) Anmeldenummer: 97250168.8
(22) Anmeldetag: 02.06.1997
(51) Int. Cl.: C25D 3/32, C25D 3/60

(54) **Verfahren zum Abscheiden von ätzfesten und porendichten Zinnschichten oder Legierungsschichten von Zinn mit weiteren Metallen**

(30) Priorität: 31.05.1996 DE 19623274
(71) Anmelder: ATOTECH Deutschland GmbH, 10553 Berlin (DE)
(72) Erfinder: Matejat, Kai-Jens, 12169 Berlin (DE); Kohnle, Franz, 12357 Berlin (DE)
(74) Vertreter: Effert, Bressel und Kollegen

(57) **Zusammenfassung**

Die Erfindung betrifft ein neues Verfahren zum elektrolytischen Abscheiden von Zinn- oder Zinnlegierungsschichten, bei denen ein wäßriges Abscheidebad verwendet wird, enthaltend Flavone und/oder Isoflavone. Mit diesem Verfahren ist es möglich, gleichmäßig dicke, kompakte, helle und porendichte Zinn- beziehungsweise Zinnlegierungsschichten abzuscheiden, wobei die Abscheidung auch durch organische Verunreinigungen in der Lösung nicht wesentlich beeinträchtigt wird.

## Beschreibung

Die vorliegende Erfindung betrifft ein Verfahren zum elektrolytischen Abscheiden von ätzfesten und porendichten Zinnschichten oder Legierungsschichten von Zinn mit weiteren Metallen in Gegenwart von beispielsweise aus Photo- oder Siebdrucklacken stammenden organischen Verunreinigungen.

Elektrolytische Zinn- und Zinnlegierungsbäder sind seit langem bekannt. Sie werden beispielsweise bei der Drahtverzinnung, Weißblechherstellung sowie Leiterplattenfertigung eingesetzt. Es wird gefordert, daß die Schichten hell, kompakt und an allen Stellen des Werkstücks möglichst gleichmäßig dick sind. Letzteres setzt voraus, daß eine gleichmäßige Schichtdicke auch bei Anwendung unterschiedlicher lokaler Stromdichten erreichbar ist. Für den Fall der Legierungsabscheidung wird überdies gefordert, daß die Legierungszusammensetzung weitgehend unabhängig von der Stromdichte ist. Ferner sollen aus den Bädern auch während einer langen Betriebsdauer Schichten mit gleichbleibend guten Eigenschaften erhalten werden.

In der Leiterplattentechnik werden Zinn- und Zinnlegierungsschichten, vorzugsweise Zinn/Blei-Schichten, als Ätzschutzschichten eingesetzt, das heißt, die Schichten werden auf den Bereichen des ganzflächig mit Kupfer überzogenen Leiterplattenlaminats abgeschieden, die den späteren Leiterzügen entsprechen und schützen die darunterliegenden Kupferschichten beim anschließenden Wegätzen der nicht mit diesen Schutzschichten überzogenen Kupferflächen. Hierzu müssen diese Schutzschichten auch ätzfest und damit porendicht sein. Üblicherweise werden zu diesem Zweck Schichten mit einer Dicke von 6 bis 12 µm abgeschieden. In feinsten Bohrungen der Leiterplatte (Durchmesser beispielsweise 0,3 mm) sind unter diesen Bedingungen dann nur noch dünnere Metallschichten abscheidbar.

Neben Verbindungen der abzuscheidenen Metalle enthalten die elektrolytischen Abscheidelösungen üblicherweise größere Mengen von Säuren, vorzugsweise Schwefelsäure, Phenolsulfonsäure, Tetrafluoroborsäure, Alkylsulfonsäuren oder Sulfaminsäure. Je nach verwendeter Säure werden die entsprechenden Salze der abzuscheidenden Metalle verwendet, beispielsweise Zinn(II)methansulfonat in Methansulfonsäure enthaltenden Bädern oder Zinn(II)sulfat in Schwefelsäure enthaltenden Bädern. Für die Leiterplattentechnik werden üblicherweise Schwefelsäure, Tetrafluoroborsäure und Methansulfonsäure enthaltende Bäder eingesetzt. Neben diesen Hauptkomponenten enthalten die Bäder Wirkzusätze, mit denen bestimmte Eigenschaften der Metallüberzüge eingestellt werden sollen. Ohne derartige Zusätze kann reines Zinn überhaupt nicht in kompakter Form abgeschieden werden, da es dann ausschließlich dendritenartige Kristallisate bildet. Um insbesondere über einen weiten Stromdichtebereich gleichmäßige Schichtdicken zu erreichen, sind derartige Wirkzusätze unentbehrlich. Sehr unterschiedliche lokale Stromdichten treten insbesondere an Leiterplatten mit sehr feinen Bohrungen auf. Im Inneren dieser Bohrungen herrscht eine sehr viel geringere Stromdichte als auf der Oberfläche der Leiterplatte. Hierzu ist es bekannt, für Tetrafluoroborsäure enthaltende Bäder verschiedene Zusätze einzusetzen, beispielsweise Pepton, Phenolphthalein sowie Octylphenolethoxylat (Manfred Jordan, Die galvanische Abscheidung von Zinn- und Zinnlegierungen, Eugen G. Leuze Verlag, Saulgau, 1993, Seite 101 für Zinn/Blei-Bäder).

Neben diesen Stoffen werden ferner Glanzbildner und Kornverfeinerer, β-Naphthol oder 4,4'-Dihydroxydiphenylsulfon verwendet (Manfred Jordan, a.a.O.). Ferner wird angegeben, daß die Bäder auch oberflächenaktive Substanzen wie beispielsweise Polyethylenglykol, Polypropylenglykol oder Derivate dieser Stoffe enthalten. Hiermit soll eine starke Polarisation der Zinnabscheidung sowie eine Emulgierung der üblicherweise wenig wasserlöslichen Glanzbildner erreicht werden (Manfred Jordan, a.a.O., Seite 75).

In der kanadischen Patentschrift 11 15 658 sind ferner Zusatzstoffe aus der Gruppe der Flavone, Flavanone, Isoflavone, Isoflavanone und Chalcone in einem Prozeß zur Elektrogewinnung von Blei offenbart. Die Lösung, aus der Blei gewonnen wird, enthält als Säure Hexafluorokieselsäure und das entsprechende Bleisalz. Mit Hilfe der Zusatzstoffe soll ein dichter, glatter und gleichmäßig dicker Bleiüberzug erreichbar sein, indem diese Stoffe kornverfeinernd und einebnend wirken. Zur Erhöhung der Löslichkeit der Zusatzstoffe im Behandlungsbad werden diese mit Ethylenoxid, Propylenoxid oder einer Mischung dieser Verbindungen chemisch umgesetzt.

Aus der US-Patentschrift 54 92 615 ist es auch bekannt, Flavone für die elektrolytische Abscheidung von Zinnschichten einzusetzen. Aus dieser Druckschrift ergibt sich jedoch nicht, welche Wirkung diese Stoffe im Abscheidebad haben.

Es hat sich herausgestellt, daß die bekannten Stoffe bei der elektrolytischen Beschichtung der Wandungen von feinsten Bohrungen in Leiterplatten wegen der dort herrschenden niedrigen Stromdichten eine lückenlose und porendichte Metallisierung mit Zinn beziehungsweise mit dessen Legierungen nicht mehr gewährleisten können. Im Falle der Abscheidung fehlerhafter Schichten besteht dann aber die Gefahr, daß die noch freiliegenden Kupferflächenbereiche in den Bohrungen beim anschließenden Ätzen mit entfernt werden, so daß der elektrische Kontakt an diesen Stellen unterbrochen und die gesamte elektrische Funktionsfähigkeit der Leiterplatten beeinträchtigt wird. Vor allem aber ist es mit den bekannten Stoffen nicht möglich, eine sichere Metallisierung zu gewährleisten, wenn das Abscheidungsbad durch organische Verunreinigungen kontaminiert ist, die insbesondere aus Photo- und Siebdrucklackschichten oder aus anderen Quellen, beispielsweise von Isolierlacken oder Verschlußstopfen, stammen. Derartige Verunreinigungen bilden sich in den Abscheidungsbädern bereits nach kurzer Zeit, wenn in ihnen die mit diesen Resisten beschichteten Leiterplatten behandelt werden.

Der vorliegenden Erfindung liegt von daher das Problem zugrunde, ein Verfahren zur Abscheidung von Zinn- oder Zinnlegierungsschichten bereitzustellen, mit der die genannten Probleme vermieden werden. Insbesondere soll es möglich sein, Zinn- oder Zinnlegierungsschichten abzuscheiden, die kompakt, hell, ätzfest, porendicht und über einen weiten Stromdichtebereich mit gleichmäßiger Schichtdicke abscheidbar sind. Diese Eigenschaften sollen vor allem auch dann erreichbar sein, wenn das Abscheidungsbad organische Verunreinigungen, insbesondere aus den Photoresisten oder Siebdrucklacken oder gegebenenfalls anderen Quellen, enthält.

Das Problem wird gelöst durch die Merkmale von Anspruch 1. Vorteilhafte Ausführungsformen sind in den Unteransprüchen angegeben.

Unter Verwendung von Flavonen und Isoflavonen als Wirkstoffe in wäßrigen, insbesondere Methansulfonsäure oder Tetrafluoroborsäure enthaltenden Lösungen einer Zinnverbindung und gegebenenfalls zusätzlicher Verbindungen weiterer abzuscheidender Metalle ist es möglich, auch in Anwesenheit von organischen Verunreinigungen, die insbesondere von Photoresisten, Siebdrucklacken oder aus anderen Quellen stammen, gleichmäßig dicke, helle, ätzfeste und porendichte Metallschichten aus dieser Lösung abzuscheiden. Ohne Zusatz der Flavone beziehungsweise Isoflavone können im Falle der verunreinigten Bäder nur schwammige, schwarze, amorphe und nicht mehr ätzfeste und porendichte Schichten erhalten werden. Mit der erfindungsgemäßen Abscheidelösung können auch in feinsten Bohrlöchern immer noch ausreichend dicke, zusammenhängende Zinn- oder Zinnlegierungsschichten abgeschieden werden.

Die Abscheidungslösung enthält neben den genannten Komponenten vorzugsweise zusätzlich noch mindestens eine oberflächenaktive Substanz aus der Gruppe der Verbindungen Polyethylenglykol, Polypropylenglykol und einem Mischpolymerisat von Ethylenglykol mit Propylenglykol. Die Wirkung dieser Zusatzstoffe zeigt sich insbesondere bei der elektrolytischen Abscheidung matter Metallüberzüge. Bei zusätzlicher Verwendung dieser Verbindungen wird die Bedeckung der zu metallisierenden Substrate noch deutlich verbessert, beispielsweise in Bereichen der Substratoberfläche, in denen das Metall mit geringer Stromdichte abgeschieden wird.

Die Wirkstoffe können in einer Konzentration von 0,02 bis 0,5 g pro Liter Lösung, vorzugsweise von 0,005 bis 2 g pro Liter Lösung, eingesetzt werden. Besonders geeignet ist Morin als erfindungsgemäßer Wirkstoff. Anstelle von Morin sind auch Quercetin und Chrysin geeignet. Ferner können auch andere Flavone und Isoflavone eingesetzt werden, sofern diese in der Abscheidelösung löslich sind.

Die oberflächenaktiven Substanzen sind insbesondere dann wirksam, wenn sie ein mittleres Molekulargewicht von 6.000 bis 15.000 g/Mol aufweisen. Diese Stoffe können in einer Konzentration von 0,1 bis 10 g pro Liter Lösung, vorzugsweise von 0,5 bis 4 g pro Liter Lösung, verwendet werden.

Als Zinnverbindung wird üblicherweise eine Verbindung des zweiwertigen Zinns vorzugsweise mit der Säure eingesetzt, die in der Abscheidelösung im Überschuß enthalten ist. Beispielsweise wird Zinn in einer Methansulfonsäure enthaltenden Lösung als Zinn(II)methansulfonat und in einer Tetrafluoroborsäurelösung als Zinn(II)tetrafluoroborat eingesetzt. Die wichtigste Zinnlegierung, die aus der erfindungsgemäßen Lösung abgeschieden werden kann, enthält zusätzlich zu Zinn das Metall Blei. Hierzu wird der Lösung auch eine Bleiverbindung zugegeben. Üblicherweise handelt es sich hierbei ebenso um das der Säure entsprechende Blei(II)salz. Für die Leiterplattentechnik wird bevorzugt eine eutektische Legierung mit 63 Gew.-% Zinn und 37 Gew.-% Blei abgeschieden. Um eine Legierung mit diesem Metallgewichtsverhältnis abzuscheiden, muß auch ein diesem Verhältnis ungefähr entsprechendes Verhältnis der Metallgehalte in der Lösung eingestellt werden. Übliche Konzentrationen von Zinn in der Lösung sind 12 bis 40 g Zinn pro Liter Lösung. Der Methansulfonsäuregehalt in der Lösung beträgt vorzugsweise 60 bis 150 g pro Liter Lösung, der der Tetrafluoroborsäure 75 bis 200 g pro Liter Lösung.

Zusätzlich zu den genannten Wirkstoffzusätzen können in der Lösung weitere Zusatzstoffe enthalten sein. Zum einen ist es vorteilhaft, der Abscheidelösung weitere oberflächenaktive Stoffe zuzugeben, durch die die Abscheidelösung eine sehr niedrige Oberflächenspannung erhält. Dadurch wird gewährleistet, daß die feinsten Bohrungen der Leiterplatten beim Eintauchen auch sicher mit der Lösung benetzt werden. Andernfalls würden Luftblasen den Abscheidevorgang in der Bohrung verhindern. Hierfür geeignet sind insbesondere Alkylphenolether von Polyglykolethern. Vorteilhaft einsetzbar ist insbesondere Tributylphenolpolyglykolether.

Ferner enthalten die Zinnbäder auch Verbindungen, die als Antioxidantien wirken. Es handelt sich hierbei um Stoffe, die verhindern, daß das in der zweiwertigen Oxidationsstufe vorliegende Zinn durch Luftsauerstoff zu vierwertigem Zinn oxidiert wird. Letzteres würde in Form der Zinnhydroxide aus der Lösung ausfallen. Als Antioxidantien sind insbesondere Hydrochinon, ein- und mehrwertige Phenole, wie beispielsweise Resorcin und Pyrogallol, Ascorbinsäure und Brenzkatechin sowie 8-Hydroxychinolin geeignet. Weitere derartige Antioxidantien sind in der Monographie von Manfred Jordan (a.a.O., Seiten 80 ff.) angegeben.

Zur Abscheidung der Zinn- oder Zinnlegierungsschichten aus der wäßrigen erfindungsgemäßen Lösung wird das zumindest oberflächlich elektrisch leitfähige Werkstück (beispielsweise ein aus Metall bestehendes Werkstück oder ein Kunststoffkörper, der an der Oberfläche mit einer Metallschicht versehen ist) zusammen mit einer Anode in Kontakt mit der Lösung gebracht und durch Anlegen einer Spannung zwischen dem Werkstück und der Anode ersteres kathodisch gegen die Anode polarisiert.

Für die Leiterplattenherstellung wird die Zinn- oder Zinnlegierungsschicht vorzugsweise als Ätzschutzschicht eingesetzt, indem diese in den Bereichen, die den späteren Leiterzügen entsprechen, auf die vorhandenen Kupferschichten abgeschieden wird. Damit sich die Schicht nicht auch auf den übrigen Schichten abscheidet, werden diese selektiv mittels einer Photoresist- oder Siebdrucklackschicht abgedeckt. Dadurch daß das Leiterplattenmaterial zusammen mit dieser Resistschicht in das Abscheidebad eingetaucht wird, kann es zu erheblichen organischen Verunreinigungen des Bades durch Ausbluten von Bestandteilen des Resists in das Bad kommen. Durch Verwendung der erfindungsgemäßen Stoffe können die mit herkömmlichen Wirkstoffkombinationen beobachteten nachteiligen Effekte, die durch die Verunreinigungen verursacht werden, vermieden werden. Es wird eine gleichmäßig dicke, geschlossene Schicht an allen Stellen der Leiterplattenoberfläche erreicht, und auch die Wandungen von kleinen Bohrungen (beispielsweise unter 0,3 mm Durchmesser) können problemlos metallisiert werden, selbst wenn die Abscheidelösung die erwähnten Verunreinigungen aus Photoresisten, Siebdrucklacken oder anderen Verunreinigungsquellen enthält. Die Dicke der abgeschiedenen Schicht beträgt zwischen 6 und 12 µm.

Erfindungsgemäße Zinn/Blei-Legierungsschichten, insbesondere mit eutektischer Zusammensetzung, können auch als elektrolytisch abgeschiedene Lotreserve verwendet werden, das heißt, die abgeschiedene Schicht kann später in einer geeigneten Vorrichtung unter Wärmezufuhr umgeschmolzen werden.

Die Zinn- und Zinn/Blei-Schichten können dadurch auf die Leiterplattenmaterialien aufgebracht werden, daß diese in die erfindungsgemäße Lösung eingetaucht werden und eine Spannung zwischen dem Leiterplattenlaminat und einer Anode angelegt wird. Hierbei wird das Leiterplattenlaminat üblicherweise in senkrechter Stellung in einen Tauchbadbehälter, in der sich die Lösung befindet, eingetaucht, so daß die Bohrungsachsen selbst horizontal angeordnet sind. Hierdurch wird der Luftaustritt aus den Bohrungen erschwert. Geeignete Mittel zur Verdrängung der Luft sind schnelle Bewegungen des Laminats senkrecht zu dessen Oberfläche, beziehungsweise parallel zur Bohrungsachse und - wesentlich wirksamer - an das Laminat angelegte Vibrationsschwingungen.

Eine wesentlich wirkungsvollere Methode zur schnellen Benetzung der gesamten Leiterplattenoberfläche einschließlich der Bohrungswandungen besteht darin, das Laminat horizontal durch eine geeignete Metallisiervorrichtung hindurchzuführen, wobei die Lösung von unten, von oben oder von beiden Seiten an die Oberflächen des Laminats mittels einer Schwall- oder Sprühtechnik herangeführt wird.

Die Temperatur der Abscheidelösung beträgt im allgemeinen zwischen 15°C und 40°C. Die anwendbaren Stromdichten liegen zwischen 0,05 und 5 A/dm².

Die folgenden Beispiele dienen zur weiteren Erläuterung der Erfindung. Wenn nicht anders angegeben, sind alle Konzentrationsangaben auf einen Liter Lösung bezogen.

### Beispiel 1:

Ein poliertes Messingblech wurde in einer in der galvanotechnischen Industrie üblichen Testzelle, einer Hullzelle, die mit einer Lösung der Zusammensetzung:
- 100 g/l: Methansulfonsäure (berechnet als 100 %ige Säure),
- 25 g/l: Zinn als Zinn(II)methansulfonat,
- 1,4 g/l: Tributylphenolpolyglykolether,
- 2,4 g/l: Polyethylenglykol, Molekulargewicht 10 000 g/Mol,
- 0,05 g/l: Morin und
- 1 g/l: Hydrochinon
gefüllt war, bei Raumtemperatur (20°C) 20 Sekunden lang mit Zinn beschichtet, indem ein konstanter Strom von 0,2 Ampere an das Blech angelegt und die Lösung nicht bewegt wurde. Als Anode diente ein Zinnblech.

Auf der der Anode zugewandten Seite des Bleches wurde hierbei eine geschlossene Zinnschicht abgeschieden, die hell, glatt und porendicht war.

### Vergleichsbeispiel 1:

Nach erneuter Durchführung des Versuches von Beispiel 1, allerdings ohne Zusatz von Morin, konnte nur eine etwa 80%-ige Überdeckung des Bleches erreicht werden, wobei vor allem im niedrigen Stromdichtebereich, das heißt in dem Bereich des Bleches, der während des Abscheidevorganges von der Anode weiter entfernt war, keine Zinnabscheidung stattfand.

### Vergleichsbeispiel 2:

Bei Wiederholung des Beispieles 1, zwar mit Morin aber anstelle von Polyethylenglykol mit einem Carbonsäureimidoetherpropionat (Rewoteric AMV, Warenname der Firma Rewo, Steinau, DE) konnte ebenfalls nur eine etwa 90%-ige Überdeckung des Bleches mit Zinn erreicht werden.

### Beispiel 2:

Beispiel 1 wurde wiederholt, allerdings mit Quercitin anstelle von Morin. Es wurde wiederum eine vollständige Überdeckung der Frontseite des Hullzell-Bleches erreicht, wobei ein heller, glatter und porendichter Überzug erhalten wurde.

Auch mit Chrysin, anstelle von Morin, konnte dasselbe gute Ergebnis bei der Verzinnung wiederholt werden.

### Beispiel 3:

Beispiel 1 wurde wiederholt. Allerdings wurde anstelle des frisch angesetzten Bades mit der in Beispiel 1 angegebenen Zusammensetzung eine Lösung verwendet, die dieselben dort aufgeführten Bestandteile enthielt, zusätzlich jedoch organische Verunreinigungen, die beim Ausbluten einer 10 Stunden in der Lösung verbliebenen und mit Photoresist (beispielsweise Negativresist von DuPont de Nemours Inc., Wilmington, USA) beschichteten Leiterplatte in die Lösung gelangt waren.

Es wurde dasselbe gute Ergebnis wie in Beispiel 1 festgestellt. Der Metallüberzug war hell, glatt und haftete fest auf dem Messingblech.

### Beispiel 4:

Zwei Hullzellen wurden in Reihe geschaltet. Die eine Zelle wurde mit der in Beispiel 1 angegebenen Lösung gefüllt, die andere mit einer Lösung der in Beispiel 1 angegebenen Zusammensetzung, die anstelle von Morin die Verbindung Resorcin in derselben Konzentration enthielt (Resorcin wirkt in diesem Fall unter anderem auch zur gleichmäßigen Beschichtung im niedrigen Stromdichtebereich). Als Kathoden dienten wiederum polierte Hullzellen-Messingbleche. Die Lösungen wurden bei Raumtemperatur gehalten und nicht bewegt. Zur Elektrolyse wurde 30 Sekunden lang ein Strom von 0,2 Ampere angelegt.

Das mittels des morinhaltigen Elektrolyten beschichtete Blech war auf der der Anode zugewandten Seite vollständig geschlossen und auf der Rückseite immerhin noch zu etwa 50 % der Oberfläche. Das andere Blech war auf der Frontseite dagegen nur zu 80 % und auf der Rückseite nur zu etwa 10 % der Oberfläche mit Zinn beschichtet.

### Beispiel 5:

Beispiel 4 wurde wiederholt. Zur Beschichtung wurde jedoch 10 Minuten lang ein Strom von 1 Ampere an jedes Blech angelegt.

Zur quantitativen Auswertung der Schichtdickenverteilung wurden die Dicken der Zinnschicht auf den Frontseiten der Bleche an verschiedenen Stellen mittels der Röntgenfluoreszenzanalysenmethode ausgemessen. Hierzu wurden Meßpunkte im Bereich der höchsten und der niedrigsten Stromdichte ausgewertet. (Die Meßwerte wurden an den Stellen des Bleches ermittelt, an denen die höchsten bzw. niedrigsten Stromdichten beim elektrolytischen Abscheiden angewendet wurden, und zwar jeweils 10 mm von den sich gegenüberliegenden Kanten des Bleches entfernt)

Auf dem Prüfblech, das mit dem morinhaltigen Elektrolyten beschichtet wurde, wurde im höchsten Stromdichtebereich eine Schichtdicke von 12,4 µm und im niedrigsten Schichtdichtebereich eine von 5,8 µm gefunden. Die Schichtdicken auf dem anderen Prüfblech (Resorcin enthaltende Lösung) lagen weiter auseinander (höchster Stromdichtebereich: 15,8 µm; niedrigster Stromdichtebereich 4,2 µm). Dies deutet darauf hin, daß die Zugabe von Morin zur Abscheidelösung eine deutlich verbessernde Wirkung auf die Metallstreuung (Vergleichmäßigung der Schichtdickenverteilung vom hohen zum niedrigen Stromdichtebereich) aufweist.

### Beispiel 6:

Beispiel 1 wurde wiederholt. Anstelle von Methansulfonsäure und Zinn(II)methansulfonat wurden nun Tetrafluoroborsäure sowie die Tetrafluoroborate von Zinn(II) und Blei(II) verwendet. Die Konzentrationen dieser Komponenten waren:
- 180 g/l: Tetrafluoroborsäure,
- 20 g/l: Zinn als Zinn(II)tetrafluoroborat,
- 13 g/l: Blei als Blei(II)tetrafluoroborat.

Es wurde wiederum eine sehr glatte, helle und porendichte Metallschicht aus einer Zinn/Blei-Legierung erhalten.

### Beispiel 7:

Beispiel 6 wurde wiederholt. Anstelle von Tetrafluoroborsäure wurde Methansulfonsäure und anstelle der Tetrafluoroborate von Zinn und Blei wurden deren Methansulfonate in den nachfolgenden Konzentrationen angewendet:
- 100 g/l: Methansulfonsäure,
- 20 g/l: Zinn als Zinn(II)methansulfonat,
- 13 g/l: Blei als Blei(II)methansulfonat.

Es wurden wiederum helle, kompakte und porendichte Zinn/Blei-Schichten erhalten.

Alle vorstehend einzeln dargestellten und beschriebenen Merkmale sowie ihre Kombinationen untereinander sind erfindungswesentlich, soweit sie nicht ausdrücklich als bekannt bezeichnet werden.

## Patentansprüche

1. Verfahren zum elektrolytischen Abscheiden von ätzfesten und porendichten Zinnschichten oder Legierungsschichten von Zinn mit weiteren Metallen auf einem elektrisch leitfähigen Werkstück mit gleichmäßiger Schichtdicke aus einer wäßrigen Abscheidelösung in Gegenwart von organischen Verunreinigungen,
- wobei der Lösung eine Zinnverbindung und gegebenenfalls mindestens eine Verbindung der weiteren Metalle sowie zusätzlich Flavone und/oder Isoflavone als Wirkstoffe zugegeben werden und
- das Werkstück zusammen mit einer Anode mit der Lösung in Kontakt gebracht und eine elektrische Spannung zwischen dem Werkstück und der Anode angelegt wird.

2. Verfahren nach Anspruch 1, dadurch gekennzeichnet, daß der Lösung zusätzlich mindestens eine oberflächenaktive Substanz, ausgewählt aus der Gruppe der Verbindungen Polyethylenglykol, Polypropylenglykol und einem Mischpolymerisat von Ethylenoxid mit Propylenoxid zugegeben werden.

3. Verfahren nach einem der vorstehenden Ansprüche, dadurch gekennzeichnet, daß die Konzentration der Wirkstoffe in der Lösung von 0,005 bis 2 g pro Liter Lösung eingestellt wird.

4. Verfahren nach einem der vorstehenden Ansprüche, dadurch gekennzeichnet, daß Morin als Wirkstoff zugegeben wird.

5. Verfahren nach einem der vorstehenden Ansprüche, dadurch gekennzeichnet, daß oberflächenaktive Substanzen mit einem mittleren Molekulargewicht von 6.000 bis 15.000 g/Mol zugegeben werden.

6. Verfahren nach einem der vorstehenden Ansprüche, dadurch gekennzeichnet, daß die Konzentration der oberflächenaktiven Substanzen in der Lösung von 0,1 bis 10 g pro Liter Lösung eingestellt wird.

7. Verfahren nach einem der vorstehenden Ansprüche, dadurch gekennzeichnet, daß Blei als weiteres Metall zugegeben wird.

8. Verfahren nach einem der vorstehenden Ansprüche, dadurch gekennzeichnet, daß der Lösung zusätzlich Phenolpolyglykolether zugegeben werden.

9. Verfahren nach einem der vorstehenden Ansprüche, dadurch gekennzeichnet, daß die Konzentration der Zinnverbindung in der Lösung auf einen Wert eingestellt wird, der 12 bis 40 g Zinn pro Liter Lösung entspricht.

10. Verfahren nach einem der vorstehenden Ansprüche, dadurch gekennzeichnet, daß die Konzentration der Methansulfonsäure in der Lösung von 60 bis 150 g pro Liter Lösung eingestellt wird.

11. Verfahren nach einem der Ansprüche 1 bis 9, dadurch gekennzeichnet, daß die Konzentration der Tetrafluoroborsäure in der Lösung von 75 bis 200 g pro Liter Lösung eingestellt wird.

12. Verfahren nach einem der vorstehenden Ansprüche, dadurch gekennzeichnet, daß der Lösung zusätzlich als Antioxidantien wirkende Verbindungen zugegeben werden.

13. Verfahren nach einem der vorstehenden Ansprüche, dadurch gekennzeichnet, daß als Werkstück ein mit Metallflächen versehenes Leiterplattenlaminat eingesetzt wird.
